# EUROPÄISCHE PATENTSCHRIFT

(11) **EP 1 287 558 B1**
(45) Veröffentlichungstag und Bekanntmachung des Hinweises auf die Patenterteilung: **13.12.2006**
(21) Anmeldenummer: 01927940.5
(22) Anmeldetag: 05.05.2001
(51) Int. Cl.: H01L 23/24

(54) **BAUELEMENTANORDNUNG UND VERFAHREN ZUR HERSTELLUNG EINER BAUELEMENTANORDNUNG**
COMPONENT ASSEMBLY AND METHOD FOR PRODUCING THE SAME
ENSEMBLE DE COMPOSANTS ET SON PROCEDE DE FABRICATION

(30) Priorität: 17.05.2000 DE 10024336
(43) Veröffentlichungstag der Anmeldung: 05.03.2003
(73) Patentinhaber: Dr. Johannes Heidenhain GmbH, 83292 Traunreut (DE)
(72) Erfinder: RISSING, Lutz, 83358 Seebruck (DE); OBERMAYER, Florian, 83329 Waging am See (DE)
(86) Internationale Anmeldenummer: PCT/EP2001/005107
(87) Internationale Veröffentlichungsnummer: WO 2001/088978

(56) Entgegenhaltungen:
- DE-A- 4 408 176
- US-A- 5 861 680
- PATENT ABSTRACTS OF JAPAN vol. 012, no. 397 (E-672), 21. Oktober 1988 (1988-10-21) -& JP 63 137460 A (IBIDEN CO LTD), 9. Juni 1988 (1988-06-09)

## Beschreibung

Die vorliegende Erfindung betrifft eine Bauelementanordnung nach dem Oberbegriff des Anspruches 1 sowie ein Verfahren zur Herstellung einer Bauelementanordnung nach dem Oberbegriff des Anspruches 12.

Zur Anordnung elektronischer und/oder optoelektronischer Bauelemente auf Trägersubstraten wie beispielsweise Leiterplatten sind verschiedene Möglichkeiten bekannt. Üblich ist etwa im Fall ungehäuster Bauelemente, dass diese zunächst auf der Leiterplatte am vorgesehenen Ort plaziert und anschließend elektrisch kontaktiert werden, beispielsweise durch Drahtbonden. Daraufhin wird z.B. mit einer Dosiernadel bzw. einem sog. Dispenser ein geschlossener Damm auf der Leiterplatte aufgebracht, der das Bauelement umgibt. In einem weiteren Prozessschritt wird schließlich eine geeignete Vergussmasse in den wannenförmigen Innenbereich des Dammes eingebracht, so dass das Bauelement und ggf. vorhandene Bonddrähte etc. durch die Vergussmasse bedeckt und gegen Umwelteinflüsse geschützt sind. Im Zusammenhang mit derartigen Bauelementanordnungen sei z.B. auf die DE 195 30 878 A1 oder aber auf die JP 61-101054 verwiesen. Beiden Dokumenten kann zudem entnommen werden, dass der jeweilige Damm zwei Dammschichten umfasst.

Im Fall von hohen Packungsdichten sowie dem Einsatz optoelektronischer Bauelemente ergeben sich nunmehr eine Reihe von Problemen. So muss in derartigen Bauelementanordnungen sichergestellt sein, dass die benötigte Grundfläche des Dammes auf dem jeweiligen Trägersubstrat möglichst klein ist, um dadurch nicht unnötigen Platz auf dem Trägersubstrat zu belegen. Der bekannte zweiteilige Dammaufbau aus der DE 195 30 878 A1 erfordert beispielsweise eine relativ große Grundfläche des Dammes auf dem Trägersubstrat und erfüllt daher diese Anforderung nicht.
Ferner ist im Fall des Einsatzes von optoelektronischen Bauelementen erforderlich, dass die über diesem Bauelement angeordnete Vergussmasse möglichst keine unerwünschte optische Wirkung für die durchtretenden Strahlenbündel aufweist. Auch dies ist im Fall der DE 195 30 878 A1 nicht gewährleistet, da an der gekrümmten Grenzfläche zwischen der Vergussmasse und der umgebenden Luft und des resultierenden Linseneffektes die durchtretenden Strahlenbündel abgelenkt werden.

Im Zusammenhang mit der bekannten Anordnung aus der JP 61-101054 ist weiterhin anzuführen, dass die beiden Dammschichten mit unterschiedlichen Schmelzpunkten eine recht aufwendige Prozesssteuerung hinsichtlich der verschiedenen Verarbeitungstemperaturen erfordern. Desweiteren resultiert prozesstechnischer Aufwand aufgrund der erforderlichen Verarbeitung mehrerer Damm-Materialien während der Herstellung einer derartigen Anordnung.

Weitere Verfahren zur Herstellung von Bauelementanordnungen auf Trägersubstraten mit geschlossenen, mehrschichtigen Dämmen sind bekannt aus der DE 4 408 176 A1 und aus der JP-63-137460.

Aufgabe der vorliegenden Erfindung ist es daher, eine Bauelementanordnung sowie ein Verfahren zu deren Herstellung anzugeben, die bestimmten Anforderungen genügen. Inbesondere soll neben einer möglichst hohen Packungsdichte und einer hinreichenden mechanischen Stabilität auch gewährleistet sein, dass optoelektronische Bauelemente einsetzbar sind. Zudem ist eine möglichst einfache Fertigung einer derartigen Bauelementanordnung wünschenswert.

Diese Aufgabe wird gelöst durch eine Bauelementanordnung mit den Merkmalen aus dem kennzeichnenden Teil des Anspruches 1.

Vorteilhafte Ausführungsformen der erfindungsgemäßen Bauelementanordnung ergeben sich aus den Maßnahmen, die in den von Anspruch 1 abhängigen Patentansprüchen aufgeführt sind.

Ferner wird die oben aufgeführte Aufgabe durch ein Verfahren mit den Merkmalen aus dem kennzeichnenden Teil des Anspruches 12 gelöst.

Vorteilhafte Ausführungsformen des erfindungsgemäßen Verfahrens ergeben sich aus den Maßnahmen, die in den von Anspruch 12 abhängigen Patentansprüchen aufgeführt sind.

Die erfindungsgemäßen Maßnahmen stellen nunmehr sicher, dass sich im Kontaktbereich zwischen benachbarten Dammschichten eine stabile Verbindung ausbildet; im Fall der Verwendung eines entsprechenden Damm-Materiales liegt in diesem Bereich etwa eine stabile Vernetzung der beiden benachbarten Dammschichten vor. Aufgrund der stabilen Verbindung in diesem Bereich resultiert zum einen ein mechanisch widerstandsfähiger Gesamtaufbau. Zum anderen ist es dadurch möglich, hohe Dämme mit vergleichsweise geringer Damm-Grundfläche auszubilden, d.h. es sind letztlich auch höhere Packungsdichten erfindungsgemäß realisierbar. Aufgrund des dann möglichen hohen Dammaufbaus kann der Innenbereich des Dammes wiederum derart mit einer geeigneten Vergussmasse ausgefüllt werden, dass diese eine nahezu ideal plane Oberfläche aufweist. Es resultiert dann keine unerwünschte optisch-ablenkende Wirkung an der Grenzfläche mit der umgebenden Luft für die durchtretenden Strahlenbündel. Wie bereits oben diskutiert ist diese eine wesentliche Anforderung, wenn optoelektronische Bauelemente in derartigen Anordnungen eingesetzt werden sollen.

Die Verwendung des identischen Damm-Materialies in allen Dammschichten bedeutet auch, dass alle Dammschichten den gleichen thermischen Ausdehnungskoeffizienten aufweisen. Es können demzufolge keine thermisch induzierten Spannungen zwischen den verschiedenen Dammschichten im Damm auftreten.

Auch fertigungstechnisch ergeben sich aufgrund der erfindungsgemäßen Maßnahmen eine Reihe von Vorteilen. So ist es im Gegensatz zur oben erwähnten JP 61-101054 nicht erforderlich, unterschiedliche Materialien für die mindestens zwei Dammschichten bereit zu halten, da die mindestens zwei Dammschichten aus dem gleichen Material bestehen. Desweiteren sind in den verschiedenen Prozessschritten, in denen die verschiedenen Dammschichten aufgebracht werden, keine unterschiedlichen Temperaturen aufgrund unterschiedlicher Schmelzpunkte bzw. Verarbeitungstemperaturen mehr erforderlich.

Schließlich ist noch aufzuführen, dass aufgrund der erfindungsgemäßen Verwendung des gleichen Materiales in den Dammschichten eine stabile Verbindung derselben gewährleistet ist. So kann etwa bei der Verwendung entsprechender Materialien eine chemische Vernetzung im Kontaktbereich beim endgültigen Aushärten resultieren. Eine hohe mechanische Belastbarkeit des Dammes ist die Folge.

Weitere Vorteile sowie Einzelheiten der vorliegenden Erfindung ergeben sich aus der nachfolgenden Beschreibung der beiliegenden Figuren.

Dabei zeigt
- Figur 1: eine seitliche Schnittansicht einer möglichen Ausführungsform der erfindungsgemäßen Bauelementanordnung;
- Figur 2: eine Draufsicht auf die Bauelementanordnung aus Figur 1;
- Figur 3: eine vergrößerte Ansicht des Dammes aus Figur 1;
- Figur 4a - 4d: jeweils verschiedene Prozessschritte einer möglichen Ausführungsform des erfindungsgemäßen Verfahrens.

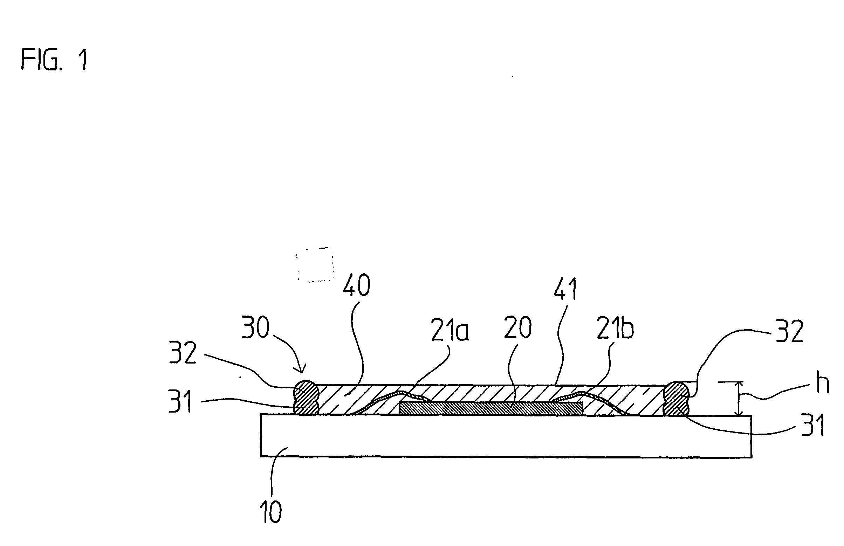

In Figur 1 ist eine Schnittansicht einer Ausführungsform der erfindungsgemäßen Bauelementanordnung schematisiert dargestellt. Beispielsweise kann es sich bei der gezeigten Ansicht um eine Teilansicht eines als Leiterplatte ausgebildeten Trägersubstrates 10 handeln, auf dem noch weitere derartige Bauelementanordnungen vorgesehen sind.
Im dargestellten Ausführungsbeispiel ist das Trägersubstrat 10 als Leiterplatte ausgebildet und fungiert als Trägerelement der Bauelementanordnung. Als geeignetes Material des Trägersubstrates 10 ist konventionelles Leiterplatten-Material vorgesehen, beispielsweise FR4 oder FR5. Alternativ hierzu könnte auch ein anders ausgebildetes Trägersubstrat 10 an dieser Stelle zum Einsatz kommen, wie etwa eine geeignete Keramik, z.B. Al₂O₃. Nicht erkennbar sind in der Darstellung der Figur 1 die im Trägersubstrat 10 verlaufenden elektrischen Leiterbahnen, die zur Kontaktierung des ungehäusten elektronischen Bauelementes 20 sowie der weiteren Bauelemente auf der Leiterplatte 10 dienen. Im vorliegenden Beispiel ist eine Kontaktierung des Bauelementes 20 mittels Bonddrähten 21a, 21 b vorgesehen. Die Bonddrähte 21a, 21b verbinden das Bauelement 20 elektrisch leitend mit den Leiterbahnen im Trägersubstrat 10. Grundsätzlich wäre an dieser Stelle auch eine alternative und/oder zusätzliche elektrische Kontaktierung des Bauelementes 20 denkbar, beispielsweise eine sog. Bändchen-Kontaktierung oder aber die Verwendung von Lötverbindern.

Das Bauelement 20 ist in dieser Ausführungsform als optoelektronisches Bauelement bzw. als sog. OPTO-ASIC ausgebildet. Dieser umfasst neben optoelektronischen Bauelementen wie etwa Photodioden noch weitere elektronische Bauelemente zur Signalverarbeitung. Selbstverständlich kann die vorliegende Erfindung aber auch in Verbindung mit konventionellen elektronischen Bauelementen wie ASICs etc. realisiert werden.

Das jeweilige Bauelement 20 ist auf dem Trägersubstrat 10 angeordnet, was z.B. durch Verkleben mit dem Trägersubstrat 10 erfolgen kann; alternativ wäre auch ein Verlöten oder aber Legieren möglich. Die vorliegende Erfindung eignet sich hierbei insbesondere zur Anordnung von ungehäusten elektronischen und/oder optoelektronischen Bauelementen auf Leiterplatten, d.h. von Bauelementen, die kein eigenes Gehäuse aufweisen und sich demzufolge besonders zur platzsparenden Anordnung anbieten.

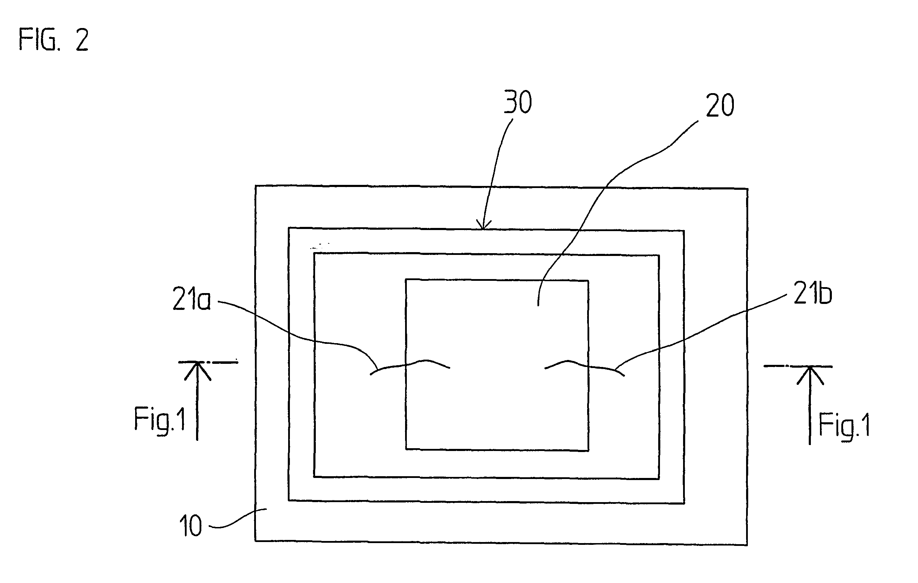

Desweiteren umfasst die erfindungsgemäße Bauelementanordnung einen Damm 30, der ebenfalls auf dem Trägersubstrat 10 angeordnet ist und das jeweilige Bauelement 20 geschlossen umgibt bzw. umläuft. Aus der in Figur 2 gezeigten Draufsicht auf die Bauelementanordnung ist erkennbar, dass in diesem Beispiel der Damm 30 das Bauelement 20 quadratisch umschließt. Selbstverständlich sind im Rahmen der vorliegenden Erfindung aber auch alternative Geometrien in Bezug auf die Form des umlaufenden Dammes 30 realisierbar, beispielsweise rechteckförmige, vieleckförmige oder runde Dammverläufe etc..

Eine erste wesentliche Funktion des Dammes 30 besteht in der erfindungsgemäßen Bauelementanordnung nunmehr darin, dass darüber die benötigte Fläche auf dem Trägersubstrat 10 begrenzt wird, die zum Vergießen des Bauelementes 20 mit einer Vergussmasse 40 erforderlich ist. Die Vergussmasse 40 wird hierzu nach Erstellen des Dammes 30 in den wannenförmigen Innenbereich des umlaufenden Dammes 30 eingebracht. Das Vergießen mittels Vergussmasse 40 dient zum Schutz des Bauelementes 20 gegenüber mechanischen Einflüssen. Hierbei wird in der dargestellten Variante aufgrund des optoelektronischen Bauelementes 20 eine transparente und niedrig-viskose Vergussmasse 40 verwendet, beispielsweise ungefülltes Epoxidharz. Die Vergussmasse 40 bedeckt im Innenbereich des Dammes 30 das Bauelement 20 inclusive der Bonddrähte 21 a, 21 b, so dass diese Elemente nach dem Aushärten der Vergussmasse 40 zuverlässig geschützt sind. Um diesen Zweck zu erfüllen, muss die Vergussmasse 40 die zu schützenden Elemente, d.h. in diesem Beispiel insbesondere auch die Bonddrähte 21 a, 21 b vollständig bedecken, wozu wiederum eine bestimmte Höhe der aufzubringenden Vergussmasse 40 erforderlich ist. Da diese beim üblichen Aufbringen mithilfe einer Dosiernadel noch nicht ausgehärtet ist und auseinanderfließt, dient der Damm 30 letztlich dazu, die benötigte Höhe der Vergussmasse 40 einzustellen, ohne dass zu viel Fläche auf dem Trägersubstrat 10 beansprucht wird.
Alternativ zur dargestellten Variante wäre es auch möglich, dass die Bonddrähte 21 a, 21 b nicht vollkommen mit der Vergussmasse 40 bedeckt werden, sondern lediglich größtenteils von derselben umschlossen werden.

Wenn in der erfindungsgemäßen Bauelementanordnung keine optoelektronischen Bauelemente vorgesehen sind, kann selbstverständlich auch eine nicht-transparente Vergussmasse 40 gewählt werden; möglich ist z.B. die Verwendung einer schwarzen Vergussmasse 40, die das jeweilige elektronische Bauelement 20 dann vor unerwünschter Bestrahlung schützt.

Ferner sei an dieser Stelle darauf hingewiesen, dass es auch ausreichen kann, lediglich das jeweilige Bauelement mittels Vergussmasse zu bedekken, wenn z.B. keine Kontaktierung mittels Drahtbonden vorgesehen ist und demzufolge auch keine Bonddrähte zu schützen wären.

Als weitere Funktion des Dammes 30 ist speziell im Fall der Verwendung optoelektronischer Bauelemente anzuführen, dass sich derart dann recht einfach nahezu ideal plane Grenzflächen zwischen der Vergussmasse 40 und der angrenzenden Luft sicherstellen lassen. An dieser Grenzfläche 41 resultiert keine unerwünschte Ablenkung einfallender oder ggf. austretender Strahlenbündel.

Desweiteren dient der Damm 30 schließlich dazu, dass sich darüber eine definierte bzw. reproduzierbare Höhe h der Bauelementanordnung über dem Trägersubstrat 10 im Verlauf der Fertigung sicher einstellen lässt. Dies ist insbesondere dann von Bedeutung, wenn eine derartige Anordnung z.B. unter beengten räumlichen Bedingungen zum Einsatz kommt. Wird etwa eine derartige Bauelementanordnung auf der Abtastplatte eines optischen Positionsmesssystems gegenüber einer rotierenden Teilscheibe eingesetzt, so ist in kompakten Systemen ein relativ kleiner Abstand zwischen der Abtastplatte und der Teilscheibe vorgesehen. Eventuelle Aufbauten auf Seiten der Abtastplatte dürfen dann eine bestimmte vorgegebene Höhe keinesfalls übersteigen.

Im dargestellten Ausführungsbeispiel der vorliegenden Erfindung besteht der Damm 30 nunmehr aus zwei Dammschichten 31, 32, die übereinander angeordnet sind und aus dem gleichen Damm-Material bestehen. Im Kontaktbereich der benachbarten Dammschichten 31, 32 liegt hierbei eine Verbindung zwischen den beiden Dammschichten 31, 32 vor. Selbstverständlich kann alternativ zum Aufbau aus zwei Dammschichten 31, 32 auch ein Dammaufbau vorgesehen werden, der mehr als zwei derartige Dammschichten 31, 32 aus dem jeweils gleichen Damm-Material umfasst, wenn eine noch größere Höhe h des Dammes 30 ggf. erforderlich sein sollte.

Als geeignetes Damm-Material dient beispielsweise ein hochviskose Vergussmasse, wie etwa gefülltes Epoxidharz oder aber ein Silkon. Vorzugsweise wird im Rahmen der vorliegenden Erfindung ein Damm-Material für die verschiedenen Schichten 31, 32 bzw. Lagen des Dammes 30 gewählt, das im Kontaktbereich benachbarter Dammschichten 31, 32 eine Vernetzung derselben und damit eine stabile Verbindung ermöglicht.

Im Fall anderer Damm-Materialien kann in diesem Kontaktbereich beispielsweise auch eine mechanische Verzahnung der rauhen Oberflächen der Dammschichten vorliegen, d.h. es können je nach Materialwahl ggf. auch andere Verbindungsmechanismen im Kontaktbereich zwischen den Dammschichten vorliegen.

Der erfindungsgemäße Aufbau des Dammes 30 aus zwei oder mehr Dammschichten 31, 32 aus dem jeweils gleichen Damm-Material gestattet nunmehr die definierte Einstellung des gewünschten Verhältnisses V aus Dammhöhe h und Dammbreite b (V = h/b). Über nachfolgend noch zu erläuternde Maßnahmen wird die Breite b des Dammes 30 definiert eingestellt, ohne dass es zu einem unerwünschten Verfließen des Damm-Materiales und damit zu einer unerwünschten Vergrößerung des benötigten Trägersubstratfläche kommt. Über das nachfolgende Aufbringen einer oder mehrer weiterer Dammschichten 32 auf die erste Dammschicht 31 lässt sich dann die erforderliche Dammhöhe h definiert bzw. reproduzierbar einstellen. Vorzugsweise liegt das Verhältnis V = h/b im Bereich 0.5 < V < 1. Grundsätzlich lassen sich durch eine geeignete Prozessführung aber auch andere Verhältnisse V einstellen.

Typische Werte für die resultierende Dammhöhe h und die Dammbreite b sind im übrigen h = 0.8mm und b = 1.0mm.

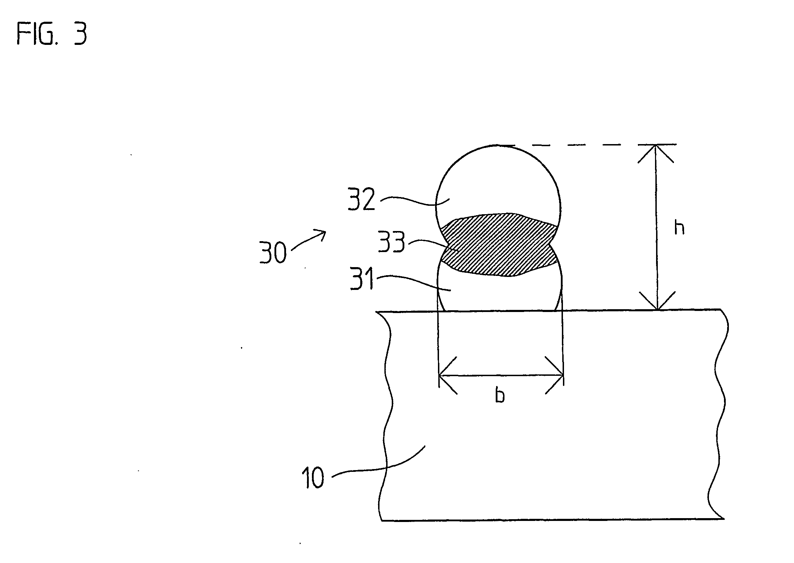

In Figur 3 ist schließlich noch eine vergrößerte Ansicht des Dammes 30 aus Figur 1 dargestellt, bestehend aus den beiden Dammschichten 31, 32. Neben den geometrischen Größen Dammhöhe h und Dammbreite b ist in Figur 3 desweiteren der Kontaktbereich 33 der aneinandergrenzenden Dammschichten 31, 32 angedeutet, in dem eine Vernetzung der beiden Dammschichten 31, 32 und damit eine stabile Verbindung derselben vorliegt.

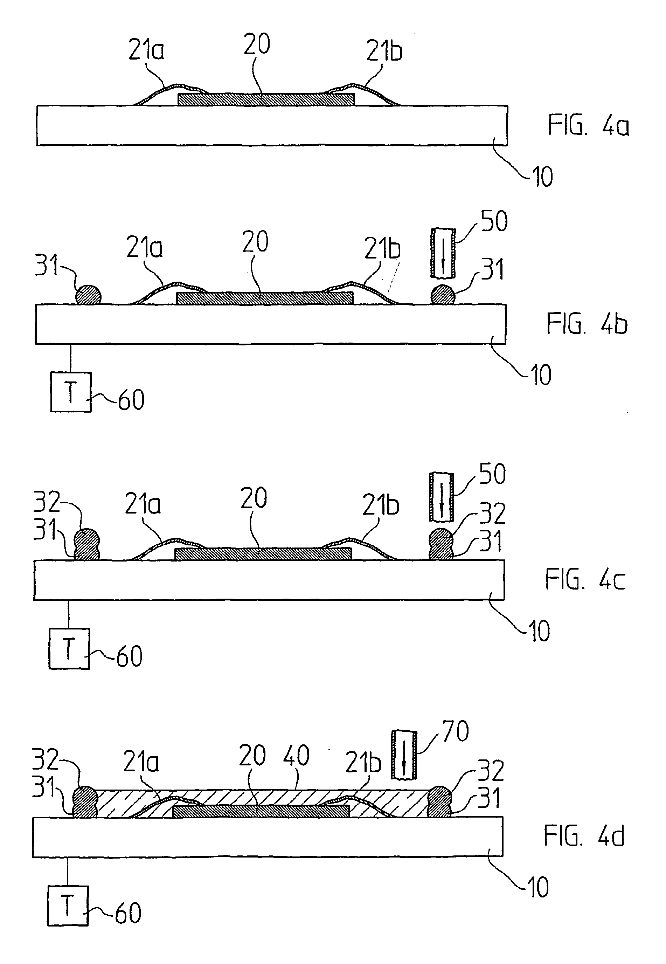

Anhand der Figuren 4a - 4d sei abschließend eine mögliche Ausführungsform des erfindungsgemäßen Verfahrens erläutert, über die eine Bauelementanordnung herstellbar ist, wie sie in den Figuren 1 - 3 beschrieben wurde.

In einem ersten Prozessschritt, dargestellt in Figur 4a, wird das ungehäuste Bauelement 20 auf dem Trägersubstrat 10 bzw. der Leiterplatte angeordnet und ggf. darauf verklebt. Ferner wird das Bauelement 20 elektrisch kontaktiert, was in bekannter Art und Weise über Drahtbonden und das Anordnen von entsprechenden Bonddrähten 21 a, 21 b erfolgen kann.

Nachfolgend wird die erste Dammschicht 31 auf dem Trägersubstrat 10 aufgebracht, die wie oben erläutert das Bauelement 20 vollständig umschließt.

Der entsprechende Prozessschritt ist in Figur 4b veranschaulicht. Das Aufbringen des entsprechenden Damm-Materiales erfolgt mit Hilfe einer schematisch angedeuteten Dosiernadel 50 in der sog. Dispense-Technik. Während des Aufbringens der ersten Dammschicht 31 wird das Trägersubstrat 10 desweiteren auf die Temperatur T aufgeheizt, was durch die ebenfalls schematisch angedeutete Heizeinrichtung 60 veranschaulicht werden soll. Das Heizen der Leiterplatte oder ggf. eines alternativen Trägersubstrates 10 bewirkt ein Vorhärten des Damm-Materiales der ersten Dammschicht 31 unmittelbar nach dem Auftreffen auf dem Trägersubstrat 10. Ein unerwünschtes und damit flächenverbrauchendes Verfließen der ersten Dammschicht 31 lässt sich derart zuverlässig verhindern. Eine definierte Einstellung der gewünschten Dammbreite b ist somit möglich. Die gewünschte Breite bzw. Höhe der ersten Dammschicht 31 lässt sich durch Abstimmen der Verfahrgeschwindigkeit der Dosiernadel 50, der aufgebrachten Menge des Damm-Materiales sowie der Temperatur T des Trägersubstrates 10 definiert einstellen.

Noch während des Aushärtens der ersten Dammschicht 31 erfolgt anschließend, wie in Figur 4c veranschaulicht, das Aufbringen der zweiten Dammschicht 32 mit Hilfe der Dosiernadel 50. Wie oben erläutert, wird für die zweite Dammschicht 32 das gleiche Damm-Material wie für die erste Dammschicht 31 verwendet. Da im oberen Teil der ersten Dammschicht 31 noch keine vollständige Aushärtung erfolgte, kommt es nach dem Aufbringen der zweiten Dammschicht 32 im Kontaktbereich zu einer Vernetzung der beiden Dammschichten 31, 32, d.h. zu einer besonders innigen und damit stabilen Verbindung der aneinanderangrenzenden Dammschichten 31, 32.

Abschließend bzw. nach Aushärten der beiden Dammschichten 31, 32 wird dann, wie in Figur 4d dargestellt, in den wannenförmigen Innenbereich des Dammes 30 die Vergussmasse 40 eingebracht, was ebenfalls mit Hilfe einer Dosiernadel 70 erfolgt. Üblicherweise wird hierzu in der entsprechenden Vorrichtung eine andere Dosiernadel 60 verwendet als in den vorhergehenden Prozessschritten. Hierbei wird soviel Vergussmasse 40 eingebracht, dass der Innenbereich des Dammes nahezu bis zur Oberkante des Dammes 30 bzw. zur Oberkante der obersten Dammschicht 32 aufgefüllt wird. Nach dem Aushärten der Vergussmassse 40 liegt dann die gegenüber mechanischen Einflüssen geschützte Bauelementanordnung vor.

Alternativ hierzu kann auch vorgesehen werden bereits unmittelbar nach dem Aufbringen der letzten Dammschicht 32 mit dem Einbringen der Vergussmasse 40 zu beginnen.

## Patentansprüche

1. Verfahren zur Herstellung einer Bauelementanordnung auf einem Trägersubstrat (10), wobei nach dem Anordnen eines Bauelementes (20) auf dem Trägersubstrat (10) ein geschlossener Damm (30) aus zwei übereinander angeordneten Dammschichten (31, 32) auf dem Trägersubstrat (10) aufgebracht wird, der das Bauelement (20) umgibt und dass zum Aufbringen des Dammes (30) zunächst die erste Dammschicht (31) aus einem Damm-Material aufgebracht wird, anschließend die zweite Dammschicht (32) aus dem identischen Damm-Material über der ersten Dammschicht (31) aufgebracht wird und im Kontaktbereich der beiden Dammschichten (31, 32) eine Verbindung derselben resultiert,
**dadurch gekennzeichnet, dass**
während des Aufbringens der ersten Dammschicht (31) das Trägersubstrat (10) geheizt wird, wodurch ein Vorhärten des Damm-Materiales der ersten Dammschicht (31) unmittelbar nach dem Auftreffen auf dem Trägersubstrat (10) bewirkt wird.

2. Verfahren nach Anspruch 1, **dadurch gekennzeichnet, dass** die zweite Dammschicht (32) aufgebracht wird, sobald die erste Dammschicht (31) im Bereich des Trägersubstrates (10) auszuhärten beginnt, aber im Kontaktbereich (33) der beiden Dammschichten (31, 32) noch nicht vollständig ausgehärtet ist.

3. Verfahren nach Anspruch 2, **dadurch gekennzeichnet, dass** die Dammschichten (31, 32) mithilfe einer Dosiernadel (50) aufgebracht werden.

4. Verfahren nach Anspruch 3, **dadurch gekennzeichnet, dass** zur Einstellung der Höhe und Breite der Dammschichten (31, 32) die Verfahrgeschwindigkeit der Dosiernadel (50), die aufgebrachte Menge des Damm-Materiales sowie die Temperatur (T) des Trägersubstrates (10) aufeinander abgestimmt werden.

5. Verfahren nach Anspruch 1, **dadurch gekennzeichnet, dass** das Bauelement (20) vor dem Aufbringen der Dammmschichten (31, 32) elektrisch leitend mit Leiterbahnen im Trägersubstrat (10) verbunden wird.

6. Verfahren nach Anspruch 5, **dadurch gekennzeichnet, dass** das Bauelement (20) durch Drahtbonden elektrisch leitend mit Leiterbahnen im Trägersubstrat (10) verbunden wird

7. Verfahren nach Anspruch 1, **dadurch gekennzeichnet, dass** nach dem Aushärten der aufgebrachten Dammschichten (31, 32) im Innenbereich des Dammes (30) eine Vergussmasse (40) eingebracht wird, die das Bauelement (20) bedeckt.

8. Verfahren nach Anspruch 1, **dadurch gekennzeichnet, dass** nach dem Aufbringen der letzten Dammschicht (32) im Innenbereich des Dammes (30) eine Vergussmasse (40) eingebracht wird, die das Bauelement (20) bedeckt.

9. Verfahren nach Anspruch 1, **dadurch gekennzeichnet, dass** im Innenbereich des Dammes (30) soviel Vergussmasse (40) eingebracht wird, dass der Innbereich des Dammes nahzu bis zur Oberkante des Dammes (30) bzw. zur Oberkante der obersten Dammschicht (32) aufgefüllt wird.

## Claims

1. Method for producing a component arrangement on a carrier substrate (10), a closed barrier (30) comprising two barrier layers (31, 32) which are disposed one above the other being applied on the carrier substrate (10) after arrangement of a component (20) on the carrier substrate (10), said barrier surrounding the component (20) and in that, in order to apply the barrier (30), firstly the first barrier layer (31) comprising a barrier material is applied, subsequently the second barrier layer (32) comprising the identical barrier material is applied above the first barrier layer (31) and a bond of the same results in the contact region of the two barrier layers (31, 32),
**characterised in that**
the carrier substrate (10) is heated during application of the first barrier layer (31), as a result of which prehardening of the barrier material of the first barrier layer (31) is effected immediately after impacting on the carrier substrate (10).

2. Method according to claim 1, **characterised in that** the second barrier layer (32) is applied as soon as the first barrier layer (31) in the region of the carrier substrate (10) begins to harden but is not yet entirely hardened in the contact region (33) of the two barrier layers (31, 32).

3. Method according to claim 2, **characterised in that** the barrier layers (31, 32) are applied by means of a metering needle (50).

4. Method according to claim 3, **characterised in that** the travel speed of the metering needle (50), the applied quantity of barrier material and also the temperature (T) of the carrier substrate (10) are coordinated with each other in order to adjust the height and width of the barrier layers (31, 32).

5. Method according to claim 1, **characterised in that** the component (20), before application of the barrier layers (31, 32), is connected in an electrically conductive manner to strip conductors in the carrier substrate (10).

6. Method according to claim 5, **characterised in that** the component (20) is connected by wire bonds in an electrically conductive manner to strip conductors in the carrier substrate (10).

7. Method according to claim 1, **characterised in that**, after hardening of the applied barrier layers (31, 32), a moulding compound (40) which covers the component (20) is introduced in the inner region of the barrier (30).

8. Method according to claim 1, **characterised in that**, after applying the last barrier layer (32), a moulding compound (40) which covers the component (20) is introduced in the inner region of the barrier (30).

9. Method according to claim 1, **characterised in that** sufficient moulding compound (40) is introduced in the inner region of the barrier (30) that the inner region of the barrier is filled nearly up to the upper edge of the barrier (30) or to the upper edge of the uppermost barrier layer (32).

## Revendications

1. Procédé pour fabriquer un ensemble de composants sur un substrat porteur (10) selon lequel, après mise en place d'un composant (20) sur ce substrat (10), un remblai fermé (30) constitué de deux couches de remblai (31, 32) superposées, est déposé sur le substrat porteur (10) en entourant le composant (20), la mise en place du remblai (30) s'effectuant en déposant d'abord la couche de remblai (31) faite d'un matériau de remblai puis, sur cette couche, la seconde couche de remblai (32) faite du même matériau, avec pour résultat la réalisation d'une liaison dans la zone de contact entre les deux couches (31, 32), **caractérisé en ce que** pendant le dépôt de la première couche de remblai (31), le substrat porteur (30) est chauffé en produisant ainsi un prédurcissement du matériau de la première couche de remblai (31) directement après son dépôt sur le substrat porteur (10).

2. Procédé selon la revendication 1, **caractérisé en ce que** la seconde couche de remblai (32) est déposée dès que la première couche de remblai (31) commence à durcir dans la zone du substrat porteur (10) tout en n'étant pas encore totalement durcie dans la zone de contact (33) des deux couches de remblai (31, 32).

3. Procédé selon la revendication 2, **caractérisé en ce que** les couches de remblai (31, 32) sont déposées au moyen d'une aiguille de dosage (50).

4. Procédé selon la revendication 3, **caractérisé en ce que** pour régler la hauteur et la largeur des couches de remblai (31, 32), la vitesse de déplacement de l'aiguille de dosage (50), la quantité apportée de matériau de remblai ainsi que la température (T) du substrat (10) sont accordées entre elles.

5. Procédé selon la revendication 1, **caractérisé en ce que** le constituant (20) avant l'apport des couches de remblai (31, 32) est relié électriquement à des pistes conductrices prévues dans le substrat porteur (10).

6. Procédé selon la revendication 5, **caractérisé en ce que** le constituant (20) est relié électriquement par des fils métallisés à des pistes conductrices du substrat porteur (10).

7. Procédé selon la revendication 1, **caractérisé en ce qu'**après durcissement des couches de remblai (31, 32) déposées, dans la zone interne du remblai (30) est déposée une masse coulée (40) qui recouvre le composant (20).

8. Procédé selon la revendication 1, **caractérisé en ce qu'**après mise en place de la dernière couche de remblai (32), dans la zone interne du remblai (30) est déposée une masse coulée (40) qui recouvre le composant (20).

9. Procédé selon la revendication 1, **caractérisé en ce que** dans la zone interne du remblai (30) est déposée suffisamment de masse coulée (40) pour que cette zone interne soit remplie à peu près jusqu'au bord supérieur du remblai (30), c'est-à-dire jusqu'au bord supérieur de la couche de remblai (32) située en haut.
